Europäisches Patentamt

European Patent Office

Office européen des brevets

(19)

(11) Publication number: **0 273 142**
**A2**

(12) # EUROPEAN PATENT APPLICATION

(21) Application number: 87116270.7

(51) Int. Cl.4: **H01L 29/90**

(22) Date of filing: 05.11.87

(30) Priority: 29.12.86 US 947138

(43) Date of publication of application:
06.07.88 Bulletin 88/27

(84) Designated Contracting States:
**DE FR GB**

(71) Applicant: **MOTOROLA INC.**
**Motorola Center 1303 Algonquin Rd.**
**Schaumburg Illinois 60196(US)**

(72) Inventor: **Cave, David L.**
**2344 E. Aspen**
**Tempe Arizona 85282(US)**

(74) Representative: **Ibbotson, Harold**
**Motorola Ltd Patent and Licensing**
**Operations - Europe Jays Close Viables**
**Industrial Estate**
**Basingstoke Hampshire RG22 4PD(GB)**

(54) Low drift emitter base oxide zener.

(57) An EBO zener is provided with an additional gate oxide layer (20) at the breakdown junction which provides a reduction in the breakdown voltage drift with time normally associated with such a device.

EP 0 273 142 A2

## LOW DRIFT EBO ZENER

### Background of the Invention

This invention relates generally to reference voltages obtained by utilizing the breakdown voltage of a PN junction and more particularly to an EBO junction, that is the emitter and base diffusion of a bipolar NPN transistor used as a zener diode, which has been covered by a thin gate oxide layer and a metal layer thereby exhibiting an improved breakdown voltage drift compared to an EBO zener without such a layer.

A common method of obtaining a voltage reference is to supply a current to a PN junction, for example the emitter base junction of a bipolar transistor, in a reverse direction such that the junction breaks down and allows the current flow. This breakdown normally occurs at a relatively constant voltage and therefore provides a relatively stable voltage reference. A specific method of implementing such a voltage reference is to utilize the emitter base junction of a bipolar transistor as a zener diode while connecting the base to the collector thereby creating a two terminal device which exhibits the characteristics of a zener diode.

When the bipolar transistor being thus used has been constructed in normal integrated circuit fashion there is located above the PN junction a layer of field oxide material. There may in addition be a metal layer located above the field oxide layer of this device. One of the common characteristics of a device so constructed is that the breakdown or zener voltage exhibits a relatively large drift with time when power is first applied to the device. While this drift may eventually decrease over a period of several hours to the point that the breakdown voltage eventually stabilizes, the initial drift can cause problems not only with an operational circuit but with the initial testing of a device by either the manufacturer or the customer. It would therefore be desirable to reduce this initial drift such that the breakdown voltage of the device would remain relatively constant even during the initial periods of power application.

### Summary of the Invention

It is an object of the present invention to provide an improved EBO zener having reduced breakdown voltage drift over a given period of time.

It is a further object of the present invention to provide a low drift EBO zener which can be manufactured using common integrated circuit manufacturing techniques.

It is still further an object of the present invention to provide a method of manufacturing a low drift EBO zener.

According to a broad aspect of the invention there is provided an improved EBO zener which comprises a thin gate oxide layer, similar to the oxide layer used to form the gate of MOS transistors, above the PN junction which is used as the zener breakdown junction. The device would include a P region diffused into an N-region to form a base region, an N+ region diffused into the P region to form an emitter region, a field oxide layer overlying at least a portion of the base region, a gate oxide layer overlying portions of the field oxide layer, the emitter region and the base region, and a metal layer overlying at least a portion of the gate oxide layer and directly contacting the emitter region.

### Brief Description of the Drawings

The above and other objects, features and advantages of the present invention will be more clearly understood from the following detailed description taken in conjunction with the accompanying drawings wherein:

FIG. 1 is a schematic diagram of a prior art voltage reference device;

FIG. 2 is a cross sectional diagram illustrating the construction of a prior art NPN transistor such as that used in FIG. 1.;

FIG. 3 is a cross sectional diagram of a portion of the integrated circuit of FIG. 2 illustrating applicant's invention;

FIG. 4 is schematic representation of applicant's invention; and

FIG. 5 is a graph illustrating the improvement in zener voltage drift provided by applicant's invention.

### Description of a Preferred Embodiment

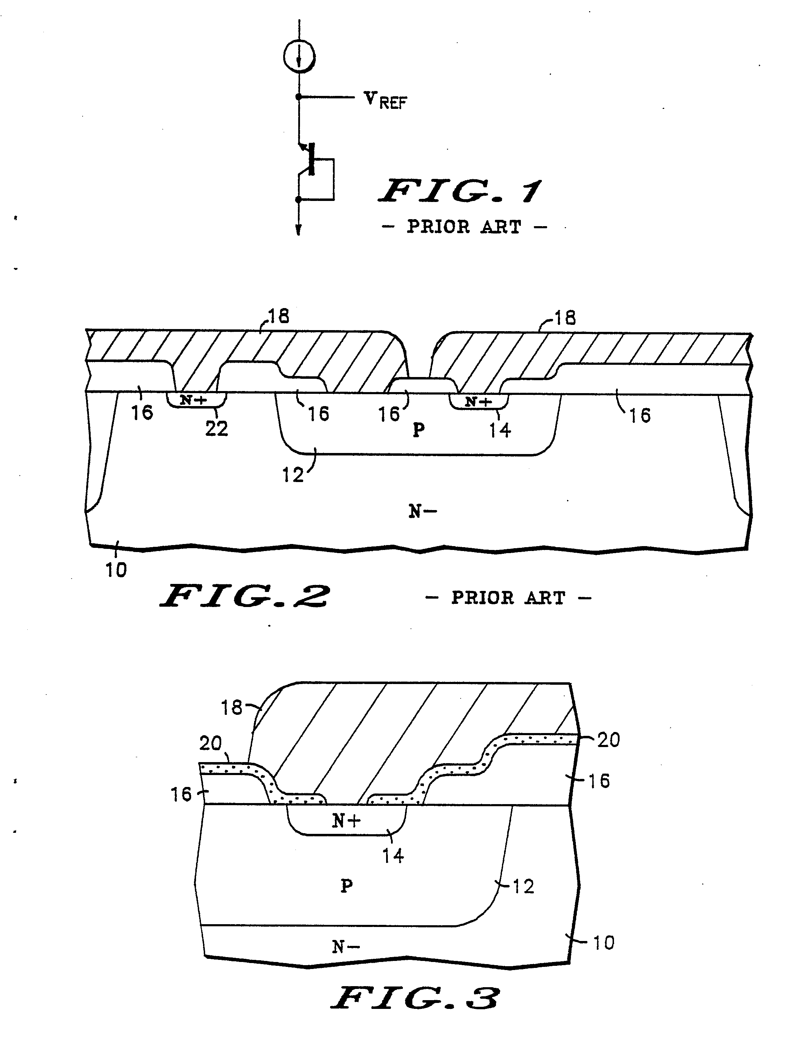

The circuit of FIG. 1 illustrates a common voltage reference circuit which utilizes the reverse breakdown voltage of the emitter base junction of the transistor wherein the base and collector terminals are tied together and connected to a ground reference. There is shown in FIG. 2 a common integrated circuit implementation of the NPN transistor illustrated in FIG 1. N-region 10 would be, for example an EPI tub region utilized as the collector of the illustrated transistor having a contact to metal layer 18 at N+ region 22. P region 12, diffused into N-region 10, would be utilized as the base region of the illustrated transistor also being contacted by metal region 18. N+ region 14 would be the emitter region of the illustrated transistor and contacted by metal layer 18 as shown. Field oxide layer 16 would cover appropriate regions of the previously mentioned regions as illustrated in FIG. 2. The junction in question, which would provide the zener breakdown voltage, is that between regions 12 and 14 of FIG. 2. As can be seen, field oxide layer 16 extends over a portion of this junction which is formed between regions 12 and 14. It is believed there are various charges accumulating at the surface between regions 12 and 16 adjacent to region 14 which change with time during initial power application and thereby alter the breakdown voltage of the emitter base junction between regions 12 and 14. A common prior art technique was to cover the junctions with a metal layer 18, such as shown in FIG. 2. This has, however, been shown to not provide an effective control of the breakdown voltage drift, which is show for example as curve 26 in FIG. 5.

As can be seen in curve 26 of FIG. 5 the reverse or zener breakdown voltage of the PN junction in question varies a significant amount during the initial 30 minutes of power application. In an attempt to reduce the effect of the charges near the junction in question, field oxide layer 16 has been removed in the area near the junction between regions 12 and 14 and replaced by a relatively thin high quality gate oxide layer 20 as illustrated in FIG. 3. This thin gate oxide layer 20 is then covered as before with metal layer 18. The result of covering this zener junction with a thin layer of gate oxide material and a metal layer is to greatly reduce the drift with time of the breakdown, or zener, voltage of the PN junction, as illustrated by curve 28 in FIG. 5.

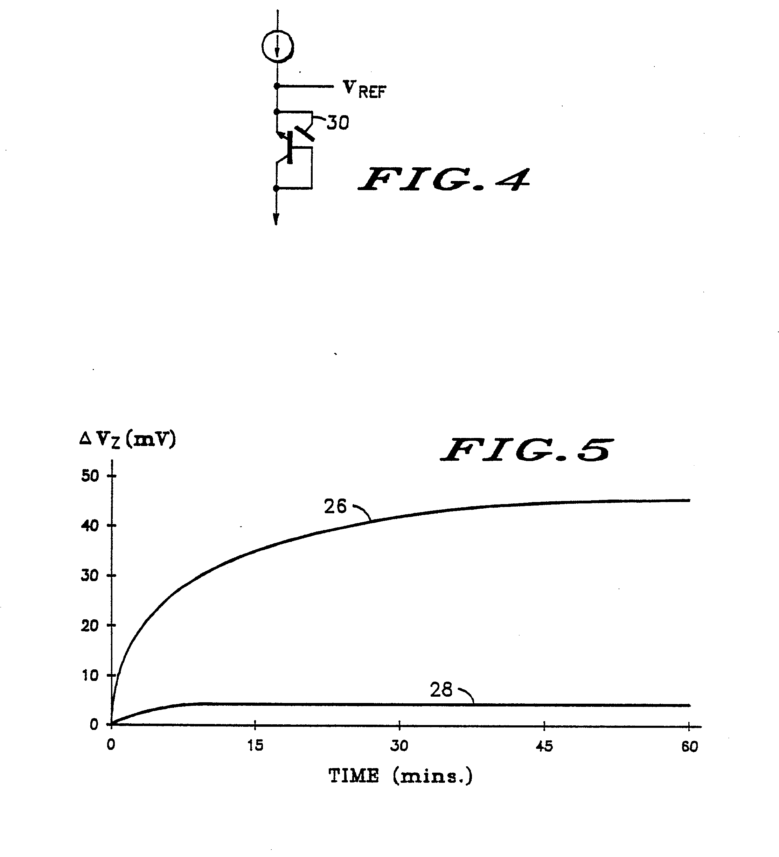

Layer 20 would be added during the otherwise conventional construction of the integrated circuit in question by removing an appropriate portion of field oxide layer 16 in a conventional manner then applying gate oxide layer 20 in a conventional manner known to those skilled in the art. This gate oxide layer 20 would be composed of material both denser and higher in quality than field oxide layer 16, such as that used to provide the gate layer in the construction of metal oxide field effect transistors. FIG. 4 is a schematic representation of the NPN transistor constructed as illustrated in FIG. 3, with the gate attached to terminal 30 intended to represent gate oxide layer 20 which covers the base emitter junction between regions 12 and 14 illustrated in FIG. 3. The addition of gate oxide layer 20 produces relatively dramatic results and can be accomplished with a few conventional steps well known to those skilled in the art.

The above description is given by way of example only. Changes in form and details may be made by one skilled in the art without departing from the scope of the invention. For example, while the above description is made in conjunction with an NPN bipolar transistor, the application of the gate oxide could be used over any single PN junction being used as a zener diode.

## Claims

1. A semiconductor device comprising:
   a first region of a first type semiconductor material;
   a second region of a second type semiconductor material diffused into a portion of said first region;
   a third region of said first type semiconductor material diffused into a portion of said second region;
   a field oxide layer overlying at least a portion of said first region;
   a gate oxide layer overlying at least a portion of said second region and a portion of said third region; and
   a metal layer overlying at least a portion of said gate oxide layer and also directly contacting at least a portion of said third region.

2. The device of claim 1 wherein said first type simiconductor material is N type and said second type semiconductor meterial is P type.

3. The device of claim 1 wherein said second region is a base region and said third region is an emitter region.

4. The device of claim 1 wherein said field oxide layer also overlies at least a portion of said second region.

5. A method of manufacturing a semiconductor device comprising the steps of:
   diffusing a first region of a first type semiconductor material into a portion of a second region of a second type semiconductor material;
   diffusing a third region of said second type semiconductor material into a portion of said first region;
   covering at least a portion of said first and third regions with a layer of field oxide material;
   removing a portion of said field oxide material from a predetermined area of said first and third regions;
   applying a layer of gate oxide material to at least a portion of said predetermined area; and
   applying a layer of metal material over at least a portion of said gate oxide layer, a portion of said metal layer coming into direct contact with said third region.

6. The method of claim 5 wherein said first type semiconductor material comprises P type material and said second type semiconductor material comprises N type material.

7. A semiconductor device comprising:

a first region of a first type semiconductor material;

a second region of a second type semiconductor material diffused into a portion of said first region;

a gate oxide layer overlying at least a portion of said first region and a portion of said second region; and

a metal layer overlying at least a portion of said gate oxide layer and also directly contacting at least a portion of said second region.

8. A method of manufacturing a semiconductor device comprising the steps of:

diffusing a first region of a first type semiconductor material into a portion of a second region of a second type semiconductor material;

covering at least a portion of said first and second regions with a layer of field oxide material;

removing a portion of said field oxide material from a predetermined area of said first and second regions;

applying a layer of gate oxide material to at least a portion of said predetermined area; and

applying a layer of metal material over at least a portion of said gate oxide layer, a portion of said metal layer coming into direct contact with said first region.

## FIG.1
### – PRIOR ART –

## FIG.2    – PRIOR ART –

## FIG.3

FIG.4

FIG.5